# EUROPÄISCHE PATENTANMELDUNG

(11) **EP 4 160 866 A1**
(43) Veröffentlichungstag der Anmeldung: **05.04.2023**
(21) Anmeldenummer: 21199915.6
(22) Anmeldetag: 29.09.2021
(51) Int. Cl.: H02J 13/00, H02J 3/00, G01R 19/25, G05B 15/02, G06Q 50/06, G06F 21/00

(54) **VERFAHREN ZUR STEUERUNG EINES ENERGIENETZES UND NETZSTEUERUNGSANORDNUNG**

(71) Anmelder: Siemens Aktiengesellschaft, 80333 München (DE)
(72) Erfinder: Henn, Volker, 91056 Erlangen (DE); Litzinger, Andreas, 90765 Fürth (DE); Romeis, Christian, 91052 Erlangen (DE)
(74) Vertreter: Siemens Patent Attorneys

(57) **Zusammenfassung**

Gegenstand der vorliegenden Erfindung ist ein Verfahren zur Steuerung eines Energienetzes, mit den Schritten:
- Empfangen von ersten Datennachrichten mit ersten Zeigermessdaten von einer ersten Phasor Measurement Unit mittels einer Kommunikationseinrichtung, und
- Ermitteln einer Abweichung zwischen den ersten Zeigermessdaten und Referenzdaten mittels einer Referenzeinrichtung, wobei für den Fall, dass die Abweichung unterhalb eines vorher festgelegten oberen Schwellenwertes und/oder oberhalb eines vorher festgelegten unteren Schwellenwertes liegt, die ersten Zeigermessdaten als plausibel erkannt werden.

Ferner ist Gegenstand der Erfindung eine entsprechende Netzsteuerungsanordnung.

## Beschreibung

Die vorliegende Erfindung betrifft ein Verfahren zur Steuerung eines Energienetzes gemäß dem Oberbegriff des Anspruchs 1 und eine Netzsteuerungsanordnung gemäß dem Oberbegriff des Anspruchs 13.

Aus der Produktbroschüre "SIGUARD PDP Grid Monitoring using Synchrophasors", Siemens AG 2021, ist eine Software für ein sog. "Wide Area Monitoring Protection and Control (WAMPAC)", also eine Weitbereichsüberwachung und Kontrolle eines Energienetzes, bekannt. Dabei werden Messdaten von sog. "Phasor Measurement Units" (PMUs), die mit hoher zeitlicher Auflösung Messdaten über Spannungsbeträge und Spannungswinkel, Strombeträge und Stromwinkel sowie Netzfrequenz und Netzfrequenzänderungsgeschwindigkeit am Installationsort der jeweiligen PMU liefern, ausgewertet. PMUs werden z.B. in einem Umspannwerk oder an einer Schaltanlage eingesetzt und mit den Transformatoren, Leitungen und/oder Sammelschienen verbunden. Messdaten werden per Internet-Protocol (IP) basierter Datenkommunikation zur Software SIGUARD PDP übermittelt, die z.B. in einer Netzleitstelle eines Netzbetreibers für das Energienetz auf einer Server-Computereinrichtung installiert ist. Die Software erkennt anhand der Messdaten z.B., ob das überwachte elektrische Energienetz eine stabile Netzfrequenz, eine stabile Spannung, eine stabile Übertragung und keine Leistungspendelungen aufweist. Ferner können Schutzgeräte im Energienetz basierend auf vorhergesagten Störungen optimiert werden, um Ausfälle zu vermeiden.

WAMPAC Systeme nutzen standardisierte Protokolle wie z.B. IEEE C37.118, IEC 60870-6-104, IEC 61850, usw., erfordern jedoch einen großen manuellen Einrichtungsaufwand. Nur so kann Interoperabilität sichergestellt werden, wenn viele unterschiedliche Geräte mit dem zentralen Auswertungsserver kommunizieren.

Die Messdaten, die in das WAMPAC System einlaufen, werden i.d.R. nicht im Hinblick auf Manipulationen überprüft. Ursachen für verfälschte oder korrumpierte Messdaten können z.B. sein: GPS Spoofing (Vortäuschen eines falschen "Global Positioning System" (GPS) Signals mit einem starken lokalen Funksender, um falsche Orts- und/oder Zeitangaben zu erzielen), Messfehler des Messinstruments, fehlerhaft ausgelesene Zustandswerte einer Schaltanlage, beschädigte Anschlussstecker (z.B. AUX) oder Kabel, Fehler in der Zeitsynchronisierung der PMUs, Cyberangriffe und andere Manipulationen. Daher ist es grundsätzlich möglich, dass verfälschte oder korrumpierte Messdaten für die weitere Auswertung im WAMPAC System verwendet werden, was zu physikalisch falschen Ergebnissen führen kann und damit auch zu nicht zielführenden Kontrolleingriffen in die Netzführung.
Im schlimmsten Fall droht ein Ausfall eines Teiles oder des gesamten überwachten Energienetzes.

Ausgehend von bekannten software-implementierten Verfahren zur Steuerung eines Energienetzes stellt sich an die Erfindung die Aufgabe, ein Verfahren zur Steuerung eines Energienetzes anzugeben, das eine besonders hohe Verfügbarkeit und Sicherheit für das Energienetz sicherstellt.

Die Erfindung löst diese Aufgabe durch ein Verfahren nach Anspruch 1.

Die Grundidee der Erfindung ist es, die einlaufenden Messdaten und Schaltzustände mittels eines zweiten Referenzsystems zu verifizieren. Dies kann z.B. eine andere Datenquelle wie ein "Meter Data Management" (MDM) System zur Erfassung und Auswertung von Smart Meter Daten, ein Digital Twin des Energienetzes, eine andere Simulation für die Messdaten oder eine Zustandsschätzung für das Energienetz aus einer Netzleitstellensoftware sein. Ferner können Kombinationen von Messdaten, die von unterschiedlichen Messgeräten am gleichen Standort stammen, und Digital Twins von Messgeräten an sich zur Überprüfung herangezogen werden.
Ein Energienetz im Sinne der Erfindung ist z.B. ein elektrisches Energieverteilungs- oder versorgungsnetz, das z.B. einzelne Regionen oder Städte versorgt. Es kann verschiedene Spannungsebenen aufweisen, z.B. eine Übertragungsebene mit Hochspannung über 52 kV Nennspannung, eine Mittelspannungsebene mit einer Nennspannung zwischen 1 kV und 52 kV sowie eine Niederspannungsebene mit einer Nennspannung unter 1 kV.

Der Begriff Steuerung bezeichnet das Ansteuern von steuerbaren Betriebsmitteln wie Schalteinrichtungen, gasisolierten Schalteinrichtungen, Stufenschaltern von Transformatoren, Kondensatorbänken, Netzreglern usw. mittels per Datenkommunikation übermittelter Steuerbefehle. Ferner kann z.B. auch das Ansteuern von Erzeugern elektrischer Energie oder Verbrauchern elektrischer Energie, um ihre jeweilige Einspeisung oder Entnahme von elektrischer Energie in das Energienetz zu steuern, umfasst sein. Dabei kann auch eine Topologieinformation über die Anordnung und Verschaltung des Energienetzes, d.h. auch unter Berücksichtigung aktueller Schaltzustände von Schalteinrichtungen, ausgewertet werden.

Datennachrichten sind z.B. digitale Nachrichten, d.h. Bitfolgen. Die Kommunikationseinrichtung kann mittels unterschiedlichster Kommunikationskanäle Datenkommunikationsverbindungen aufbauen, z.B.: "Powerline Communication" Verbindungen über eine Stromleitung, Funkverbindungen nach dem 2G,3G,4G,5G oder long range radio Standard oder optische Verbindungen mit Lichtwellenleitern. Ferner können herkömmliche Kupferkabel der Datenübertragungstechnik eingesetzt werden.

Die Kommunikationseinrichtung, die Kontrolleinrichtung und die Referenzeinrichtung sind z.B. Hardwarekomponenten und/oder Softwarekomponenten, die beispielsweise in einem Feldgerät oder einem Schutzgerät vor Ort in einem Umspannwerk angeordnet sind. Dies bietet Vorteile gegenüber einer entfernt angebotenen Lösung, z.B. per Cloud-Infrastruktur, weil die PMUs Messdaten mit einer zeitlichen Auflösung im ms-Bereich (z.B. alle 20 ms) liefern, was für die Weitbereichsregelung den wesentlichen Vorteil bietet, in Sekundenbruchteilen bereits Störungen erkennen und Gegenmaßnahmen einleiten zu können. Ein Anbieten dieser Funktionalitäten (Kontrolleinrichtung, Referenzeinrichtung) als Softwarekomponenten auf einer entfernt angeordneten Server-Computeranordnung oder in einer Cloud kann jedoch mit Vorteil eingesetzt werden, wenn sehr kurze Latenzen für die Datenkommunikation sichergestellt werden können (unter 100 ms).

Ein Feldgerät, ein Schutzgerät oder eine Server-Computeranordnung weisen im Sinne der Erfindung Datenprozessorressourcen wie z.B. "Central Processing Units" (CPUs) und/oder "Graphics Processing Units" (GPUs) sowie Datenspeicherressourcen wie z.B. "Solid state disks" (SSDs) oder Magnetfestplatten (HDDs) auf.

Zeigermessdaten weisen z.B. einen Spannungswert, einen Stromstärkewert, einen Phasenwinkel, ein Zeitstempel und ggf. eine geografische Position auf.

Eine Abweichung im Sinne der Erfindung ist z.B. ein positiver oder negativer Zahlenwert, der sich bei der Subtraktion z.B. eines Referenzwertes für die Spannung von einem von der PMU gemessenen Spannungswert ergibt. Beträgt die von der PMU gemessene Spannung z.B. 395 V und der Referenzwert 380 V, so beträgt die Abweichung A = 395 V - 380 V = 15 V, was einer prozentualen Abweichung von Aₚ = 15 V / 395 V = 3,8 % entspricht. Für die Stromstärke und den Phasenwinkel kann gleichermaßen verfahren werden. Es können neben einer prozentualen Abweichung selbstredend auch die absoluten Werte der Abweichung verwendet werden.

Der obere und der untere Schwellenwert definieren ein zulässiges Intervall der Abweichung zw. Messdaten und Referenzdaten. Es kann z.B. für jede Messgröße (Spannung, Stromstärke, Phasenwinkel) ein eigener absoluter oder prozentualer oberer und unterer Schwellenwert festgelegt sein oder auch ein prozentualer Wert, der für alle Messgrößen gilt. Als ein vorher festgelegter oberen Schwellenwert kann z.B. 410 V festgelegt werden oder eine prozentuale Abweichung von 3 % bis 5 %, bevorzugt 5 % bis 10 %. Wird beispielsweise als oberer Schwellenwert 5 % und als unterer Schwellenwert -6 % festgelegt, so ist die eingangs berechnete Abweichung der Spannung von 3,8 % plausibel. Entsprechend kann der gemessene Wert von 395 V weiterverwendet werden, um die Weitbereichskontrolle durchzuführen.

Für die Festlegung zulässiger Abweichungen ist bedenkenswert, dass PMUs typischerweise über recht genaue Messinstrumente verfügen und bauartbedingt Toleranzen von z.B. 0,1 % bis 0,5 % aufweisen, während RTUs typischerweise Toleranzen von z.B. 1 % bis 3 % aufweisen. Aufgrund der vergleichsweise hohen bauartbedingten Messungenauigkeit von RTUs ist es daher sinnvoll, die Schwellenwerte so zu wählen, dass ein Bereich für die Messungenauigkeit der Messsysteme umfasst ist.

Es kann beispielsweise auch nur eine betragsmäßige Abweichung berechnet werden, die z.B. innerhalb von +/- 5 % des gemessenen Wertes zulässig ist.

Es ist ein wesentlicher Vorteil der Erfindung, dass die Vertrauenswürdigkeit der eingehenden Messdaten für das WAMPAC System verbessert wird, so dass in der Folge auch eine verbesserte Kontrolle des Energienetzes erreicht wird, um Störungen rasch mit sinnvollen Gegenmaßnahmen entgegen wirken zu können. Entscheidungen bzw. Aktionen (z.B. Senden eines Steuerbefehls zum Öffnen eines Schalters), die das Energienetz in kritischen Situationen beeinflussen, werden verlässlicher und resilienter gegenüber verfälschten Daten als dies bei bisherigen Systemen der Fall war.

In einer bevorzugten Ausführungsform des erfindungsgemäßen Verfahrens werden mittels einer Kontrolleinrichtung die als plausibel erkannten ersten Zeigermessdaten für eine Erkennung eines kritischen Systemzustands berücksichtigt und Gegenmaßnahmen ermittelt. Dies ist ein Vorteil, weil die auf Plausibilität überprüften PMU-Messdaten zur Weitbereichssteuerung eingesetzt werden.

In einer weiteren bevorzugten Ausführungsform des erfindungsgemäßen Verfahrens werden mittels der Kontrolleinrichtung anhand der Gegenmaßnahmen Steuerbefehle für Schutzgeräte und/oder steuerbare Betriebsmittel festgelegt, und mittels der Kommunikationseinrichtung werden zweite Datennachrichten mit den Steuerbefehlen an die Schutzgeräte und/oder die steuerbaren Betriebsmittel gesendet. Dies ist ein Vorteil, weil mit den Gegenmaßnahmen sehr schnell in die Betriebsführung des Energienetzes eingegriffen werden kann, um Störungen zu beseitigen. Beispielsweise kann eine Gegenmaßnahme ein Öffnen eines Schalters (d.h. ein Lastabwurf) sein.

In einer weiteren bevorzugten Ausführungsform des erfindungsgemäßen Verfahrens werden mittels einer Referenzeinrichtung die Referenzdaten anhand eines Digital Twins des Energienetzes ermittelt. Ein Digital Twin bzw. digitaler Zwilling des realen Systems ist im Sinne der Erfindung eine Software, die das reale Energienetz simulieren kann. Aus der Simulation können Referenzwerte für Messdaten an allen Messpunkten im Energienetz geschätzt werden. Dies ist ein Vorteil, weil auf diese Weise einfach und genau die empfangenen Messdaten verifiziert werden können.

In einer weiteren bevorzugten Ausführungsform des erfindungsgemäßen Verfahrens werden mittels der Referenzeinrichtung die Referenzdaten anhand eines Meter Data Management Systems ermittelt. Ein Meter Data Management Systems empfängt z.B. alle 15 Minuten von sog. Smart Metern Energieverbrauchswerte sowie Spannungs- und Stromstärkewerte an den Messstellen, die typischerweise am Netzanschlusspunkt von Gebäuden installiert sind. Dies ist ein Vorteil, weil auf diese Weise einfach und genau die empfangenen Messdaten verifiziert werden können.

In einer weiteren bevorzugten Ausführungsform des erfindungsgemäßen Verfahrens werden mittels der Referenzeinrichtung die Referenzdaten anhand einer Zustandsschätzung für das Energienetz ermittelt. Eine Zustandsschätzung wird beispielsweise von einer Leitstellensoftware auf einer Server-Computeranordnung in der Netzleitstelle des Betreibers des Energienetzes durchgeführt. Eingangsgrößen sind u.a. betragsmäßig angegebene Messdaten für Spannung und Stromstärke, die von Feldgeräten wie sog. "Remote Terminal Units" (RTU) geliefert werden. Diese Messdaten der RTUs enthalten entsprechend keine Phaseninformationen, sind also keine Zeigermessdaten wie die von dem PMUs gelieferten Daten. Liegt eine Zustandsschätzung vor, kann aus der Zustandsschätzung auf Phasenwinkel am Messort der ersten Phasor Measurement Unit geschlossen und ein Vergleich durchgeführt werden. Die Zustandsschätzung kann beispielsweise per Datennachricht mittels der Kommunikationseinrichtung empfangen werden.

In einer weiteren bevorzugten Ausführungsform des erfindungsgemäßen Verfahrens werden mittels der Referenzeinrichtung die Referenzdaten anhand von Messdaten, die von einem zweiten Messgerät stammen, ermittelt. Dies ist ein Vorteil, weil eine Situation ausgenutzt werden kann, bei der das zweite Messgerät und die erste Phasor Measurement Unit vergleichbare Daten liefern.

In einer weiteren bevorzugten Ausführungsform des erfindungsgemäßen Verfahrens wird für das zweite Messgerät ein Messgerät verwendet, das der gleichen Sammelschiene wie die erste Phasor Measurement Unit zugeordnet ist, und es wird mittels der Referenzeinrichtung unter Berücksichtigung von topologischen Informationen über das Energienetz die Zuordnung zur gleichen Sammelschiene überprüft. Beispielswiese weist eine Sammelschiene 3 bis 4 angeschlossene Leitungen auf, für die topologische Information vorliegt, dass die entsprechenden Leistungsschalter, die die Leitungen mit der Sammelschiene verbinden, geschlossen sind. In einem solchen Fall findet sich häufig an der Sammelschiene eine installierte PMU und ggf. an einer oder mehreren Leitungen ein zweites Messgerät, dass z.B. Spannung und Stromstärke betragsmäßig messen kann. Ggf. ist auch eine weitere Sammelschiene mit einer weiteren PMU angeschlossen und galvanisch verbunden. In diesen Fällen sollten alle Messgeräte vergleichbare Messdaten liefern. Die topologischen Informationen können beispielsweise von einer Netzleitstelle oder einem Schutzgerät bezogen werden.

In einer Weiterbildung kann aus den von der ersten Phasor Measurement Unit und mindestens einem weiteren zweiten Messgerät gelieferten Messdaten ein Mittelwert gebildet werden, der für die Weitbereichsregelung berücksichtigt wird. Dies kann erfolgen, wenn die von der ersten Phasor Measurement Unit gemessenen Zeigermessdaten als plausibel erkannt wurden. Es kann auch ein gewichtetes Mittel errechnet werden, wobei beispielsweise nach Art des Messgeräts im Hinblick auf die eingangs erläuterte bauartbedingte Messgenauigkeit gewichtet wird. Messdaten einer RTU werden also höher gewichtet als Messdaten einer PMU. Ferner kann nach Betriebsdauer der verwendeten Messinstrumente gewichtet werden, also wird z.B. ein 10 Jahres altes Messgerät geringer gewichtet als ein Messgerät, das weniger als 5 Jahre in Betrieb ist.

In einer weiteren bevorzugten Ausführungsform des erfindungsgemäßen Verfahrens wird für das zweite Messgerät eine zweite Phasor Measurement Unit verwendet wird, die an einem anderen Ende einer Übertragungsleitung als die erste Phasor Measurement Unit eingesetzt wird, wobei mittels der Referenzeinrichtung ein elektrisches Model der Übertragungsleitung berücksichtigt wird. Ist die Impedanz der Leitung im Rahmen des elektrischen Models bekannt, so kann anhand der Messdaten der zweite Phasor Measurement Unit neben Spannung und Stromstärke auch errechnet werden, welcher Phasenwinkel am Messpunkt der ersten Phasor Measurement Unit zu erwarten ist.

In einer weiteren bevorzugten Ausführungsform des erfindungsgemäßen Verfahrens werden mittels der Kommunikationseinrichtung erste Datennachrichten empfangen, die einen Zeitstempel und/oder geografische Koordinaten beinhalten, und mittels der Referenzeinrichtung wird zwischen dem Zeitstempel und/oder den geografischen Koordinaten der ersten Phasor Measurement Unit und Referenzdaten für den Zeitstempel und/oder die geografischen Koordinaten jeweils eine Abweichung ermittelt. Diese Variante ist besonders von Vorteil, um eine böswillige Manipulation eines Dritten zu erkennen. Beispielsweise kann ein Angreifer darauf abzielen, die Erfassung von Zeitstempel und/oder geografischen Koordinaten, die mittels GPS ermittelt werden, am Installationsort der ersten Phasor Measurement Unit zu stören. Er kann z.B. ein sog. GPS-Spoofing einsetzen, bei dem lokal mit einem starken Funksender ein verfälschtes GPS-Signal abgestrahlt wird, dass viel stärker als das echte, von Satelliten empfangene GPS-Signal ist. Auf diese Weise kann der ersten Phasor Measurement Unit z.B. vorgegaukelt werden, dass der Installationsort z.B. in einer anderen Zeitzone liegt. Entsprechend würde die Weiterverarbeitung der gesendeten Zeigermessdaten mit falschem Zeitstempel zu falschen Einschätzungen im Rahmen der Weitbereichsregelung führen.

In einer weiteren bevorzugten Ausführungsform des erfindungsgemäßen Verfahrens werden mittels der Referenzeinrichtung die Referenzdaten für den Zeitstempel und/oder die geografischen Koordinaten unter Berücksichtigung einer Zeitverzögerung in dem Zeitstempel ermittelt. Hier wird überprüft, ob die Laufzeit der Funksignale von den Satelliten plausibel in Hinblick auf die übermittelte geografische Position und den Zeitstempel ist.

Ferner können Manipulationen oder Fehler leicht erkannt werden, wenn die Zeitstempel von Messdaten, die von einer PMU geliefert werden, nicht kontinuierlich sind, sondern vielmehr Sprünge von z.B. einigen Sekunden oder mehr aufweisen.

In einer weiteren bevorzugten Ausführungsform des erfindungsgemäßen Verfahrens werden mittels der Referenzeinrichtung die Referenzdaten für den Zeitstempel und/oder die geografischen Koordinaten unter Berücksichtigung einer vorbekannten geografischen Position der ersten Phasor Measurement Unit ermittelt. Dies setzt voraus, dass beispielsweise ein Geoinformationssystem bereitgestellt ist, in dem z.B. die bei der Geräteinstallation erfassten GPS-Koordinaten von Phasor Measurement Units erfasst sind.

Ausgehend von bekannten Netzsteuerungsanordnungen stellt sich ferner an die Erfindung die Aufgabe, eine Netzsteuerungsanordnung zur Steuerung eines Energienetzes anzugeben, mittels derer eine besonders hohe Verfügbarkeit und Sicherheit für das Energienetz sicherstellt wird.

Die Erfindung löst diese Aufgabe durch eine Netzsteuerungsanordnung nach Anspruch 13. Bevorzugte Ausführungsformen sind in den abhängigen Ansprüchen 14 und 15 angegeben. Es ergeben sich für die erfindungsgemäße Netzsteuerungsanordnung und ihre Ausführungsform sinngemäß die gleichen Vorteile wie eingangs für das erfindungsgemäße Verfahren erläutert.

In einer bevorzugten Ausführungsform der erfindungsgemäßen Netzsteuerungsanordnung ist die Kontrolleinrichtung ausgebildet, anhand der Gegenmaßnahmen Steuerbefehle für Schutzgeräte und/oder steuerbare Betriebsmittel festzulegen, und die Kommunikationseinrichtung ist ausgebildet, zweite Datennachrichten mit den Steuerbefehlen an die Schutzgeräte und/oder die steuerbaren Betriebsmittel zu senden.

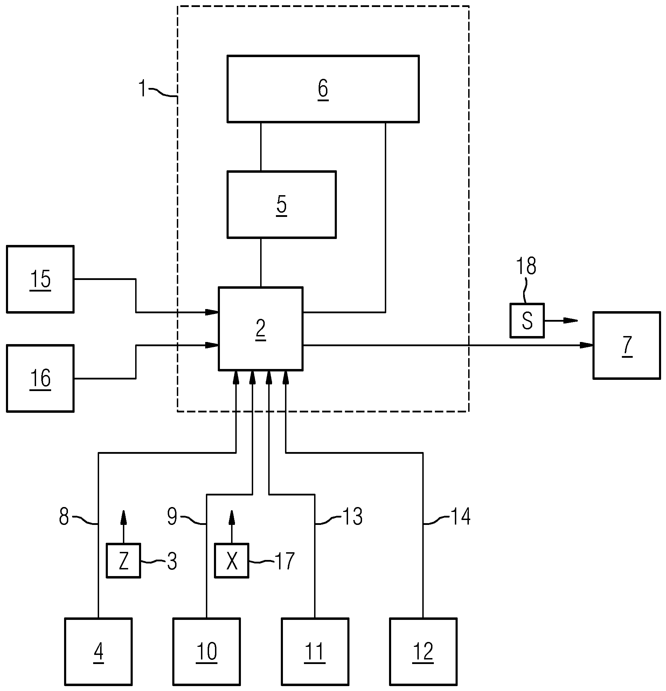

Zur besseren Erläuterung der Erfindung zeigt die Figur in schematischer Darstellung ein bevorzugtes Ausführungsbeispiel der Erfindung.

Eine Netzsteuerungsanordnung 1 für ein Energienetz (nicht dargestellt) weist eine Kommunikationseinrichtung 2 und eine Referenzeinrichtung 5 sowie eine Kontrolleinrichtung 6 auf.

Eine erste Phasor Measurement Unit 4 sendet erste Zeigermessdaten z mit einer ersten Datennachricht 3 mittels einer Datenkommunikationsverbindung 8, die von der Kommunikationseinrichtung 2 empfangen wird. Eine zweites Messgerät 10 ist als eine zweite Phasor Measurement Unit ausgebildet, die mit einer zweiten Datennachricht 17 zweite Zeigermessdaten x mittels einer Datenkommunikationsverbindung 9 sendet. Beide Phasor Measurement Units 4,10 sind beispielsweise an der gleichen Sammelschiene angeschlossen oder über eine Leitung verbunden. Im letztgenannten Fall kann mit der Referenzeinrichtung 5 errechnet werden, welche Zeigermessdaten unter Berücksichtigung eines elektrischen Modells der Leitung zu erwarten wären.

Die Referenzeinrichtung 5 dient dazu, eine Abweichung zwischen den ersten Zeigermessdaten z und Referenzdaten, in diesem Fall den zweiten Zeigermessdaten x, zu ermitteln.
In dem Fall, dass die Abweichung unterhalb eines vorher festgelegten oberen Schwellenwertes und/oder oberhalb eines vorher festgelegten unteren Schwellenwertes liegt, werden die ersten Zeigermessdaten von der Referenzeinrichtung 5 als plausibel erkannt und an die Kontrolleinrichtung 6 weitergeben.

Die Kontrolleinrichtung 6 kann die als plausibel erkannten ersten Zeigermessdaten z für eine Erkennung eines kritischen Systemzustands berücksichtigen und Gegenmaßnahmen ermitteln, die über die Kommunikationseinrichtung 2 mithilfe einer Datennachricht 18 mit Steuerbefehlen S an ein steuerbares Betriebsmittel 7 wie z.B. einen Leistungsschalter gesendet und umgesetzt werden können. Die Kontrolleinrichtung 6 kann außerdem über eine "Supervisory Control and Data Acquisition" (SCADA) Funktionalität verfügen und eine eigene Zustandsschätzung für das elektrische Energienetz erstellen. Zudem kann eine Funktionalität zur Störungserkennung auf Basis der Zustandsschätzung vorgesehen sein.

Eine andere Möglichkeit für einen Plausibilitätscheck besteht, wenn unterschiedliche Messysteme wie eine PMU 11, die Zeigermessdaten liefert, und eine RTU 12, die betragsmäßige Messwerte für Spannung und Stromstärke liefert, am gleichen Ort eingesetzt werden. In einem solchen Fall kann mittels der RTU-Messdaten durch die Kontrolleinrichtung eine Zustandsschätzung erstellt werden, von der auf die erwartbaren Zeigermessdaten der PMU rückgerechnet werden kann. Die so gewonnenen Referenzdaten können dann wie eingangs erläutert von der Referenzeinrichtung 5 mit den Zeigermessdaten der PMU 11 verglichen werden.

Als weitere Datenquellen zur Ermittlung von Referenzdaten können z.B. ein Meter Data Management System 15 und eine Geoinformationsdatenbank 16 dienen, in der geografische Positionen der PMUs 4,10,11 und der RTU 12 gespeichert sind.

## Patentansprüche

1. Verfahren zur Steuerung eines Energienetzes, mit dem Schritt:
- Empfangen von ersten Datennachrichten (3) mit ersten Zeigermessdaten (z) von einer ersten Phasor Measurement Unit (4) mittels einer Kommunikationseinrichtung (2),
**gekennzeichnet durch** den Schritt:
- Ermitteln einer Abweichung zwischen den ersten Zeigermessdaten (z) und Referenzdaten mittels einer Referenzeinrichtung (5), wobei für den Fall, dass die Abweichung unterhalb eines vorher festgelegten oberen Schwellenwertes und/oder oberhalb eines vorher festgelegten unteren Schwellenwertes liegt, die ersten Zeigermessdaten (z) als plausibel erkannt werden.

2. Verfahren nach Anspruch 1,
**dadurch gekennzeichnet, dass**
mittels einer Kontrolleinrichtung (6) die als plausibel erkannten ersten Zeigermessdaten (z) für eine Erkennung eines kritischen Systemzustands berücksichtigt und Gegenmaßnahmen ermittelt werden.

3. Verfahren nach Anspruch 1 oder 2,
**dadurch gekennzeichnet, dass**
mittels der Kontrolleinrichtung (6) anhand der Gegenmaßnahmen Steuerbefehle für Schutzgeräte und/oder steuerbare Betriebsmittel (7) festgelegt werden, und
mittels der Kommunikationseinrichtung (2) zweite Datennachrichten (18) mit den Steuerbefehlen (S) an die Schutzgeräte und/oder die steuerbaren Betriebsmittel (7) gesendet werden.

4. Verfahren nach einem der vorhergehenden Ansprüche, **dadurch gekennzeichnet, dass**
mittels der Referenzeinrichtung (5) die Referenzdaten anhand eines Digital Twins des Energienetzes ermittelt werden.

5. Verfahren nach einem der vorhergehenden Ansprüche, **dadurch gekennzeichnet, dass**
mittels der Referenzeinrichtung (5) die Referenzdaten anhand eines Meter Data Management Systems (15) ermittelt werden.

6. Verfahren nach einem der vorhergehenden Ansprüche, **dadurch gekennzeichnet, dass**
mittels der Referenzeinrichtung (5) die Referenzdaten anhand einer Zustandsschätzung für das Energienetz ermittelt werden.

7. Verfahren nach einem der vorhergehenden Ansprüche, **dadurch gekennzeichnet, dass**
mittels der Referenzeinrichtung (5) die Referenzdaten anhand von Messdaten (x), die von einem zweiten Messgerät (10,12) stammen, ermittelt werden.

8. Verfahren nach Anspruch 7, **dadurch gekennzeichnet, dass** für das zweite Messgerät (10,12) ein Messgerät verwendet wird, das der gleichen Sammelschiene wie die erste Phasor Measurement Unit zugeordnet (4,11) ist, und dass mittels der Referenzeinrichtung (5) unter Berücksichtigung von topologischen Informationen über das Energienetz die Zuordnung zur gleichen Sammelschiene überprüft wird.

9. Verfahren nach einem der vorhergehenden Ansprüche, **dadurch gekennzeichnet, dass**
für das zweite Messgerät eine zweite Phasor Measurement Unit (10) verwendet wird, die an einem anderen Ende einer Übertragungsleitung als die erste Phasor Measurement Unit (4) eingesetzt wird, wobei mittels der Referenzeinrichtung (5) ein elektrisches Model der Übertragungsleitung berücksichtigt wird.

10. Verfahren nach einem der vorhergehenden Ansprüche, **dadurch gekennzeichnet, dass**
mittels der Kommunikationseinrichtung (2) erste Datennachrichten (3) empfangen werden, die einen Zeitstempel und/oder geografische Koordinaten beinhalten, und dass mittels der Referenzeinrichtung (5) zwischen dem Zeitstempel und/oder den geografischen Koordinaten der ersten Phasor Measurement Unit (4) und Referenzdaten für den Zeitstempel und/oder die geografischen Koordinaten jeweils eine Abweichung ermittelt wird.

11. Verfahren nach Anspruch 10, **dadurch gekennzeichnet, dass** mittels der Referenzeinrichtung (5) die Referenzdaten für den Zeitstempel und/oder die geografischen Koordinaten unter Berücksichtigung einer Zeitverzögerung in dem Zeitstempel ermittelt werden.

12. Verfahren nach Anspruch 10 oder 11, **dadurch gekennzeichnet, dass**
mittels der Referenzeinrichtung (5) die Referenzdaten für den Zeitstempel und/oder die geografischen Koordinaten unter Berücksichtigung einer vorbekannten geografischen Position der ersten Phasor Measurement Unit (4) ermittelt werden.

13. Netzsteuerungsanordnung (1) für ein Energienetz, aufweisend:
eine Kommunikationseinrichtung (2), die ausgebildet ist,
erste Datennachrichten (3) mit ersten Zeigermessdaten (z) von einer ersten Phasor Measurement Unit (4) zu empfangen,
**dadurch gekennzeichnet, dass**
eine Referenzeinrichtung (5) ausgebildet ist, eine Abweichung zwischen den ersten Zeigermessdaten (z) und Referenzdaten zu ermitteln, wobei für den Fall, dass die Abweichung unterhalb eines vorher festgelegten oberen Schwellenwertes und/oder oberhalb eines vorher festgelegten unteren Schwellenwertes liegt, die ersten Zeigermessdaten (z) als plausibel erkannt werden.

14. Netzsteuerungsanordnung nach Anspruch 13,
**dadurch gekennzeichnet, dass**
eine Kontrolleinrichtung (6) ausgebildet ist, die als plausibel erkannten ersten Zeigermessdaten (z) für eine Erkennung eines kritischen Systemzustands zu berücksichtigen und Gegenmaßnahmen zu ermitteln.

15. Netzsteuerungsanordnung nach Anspruch 13 oder 14, **dadurch gekennzeichnet, dass**
die Referenzeinrichtung (5) ausgebildet ist, ein Verfahren gemäß einem der Ansprüche 4 bis 12 durchzuführen.
